# EUROPEAN PATENT APPLICATION

(11) **EP 2 693 351 A1**
(43) Date of publication of application: **05.02.2014**
(21) Application number: 13178946.3
(22) Date of filing: 01.08.2013
(51) Int. Cl.: G06F 17/50

(54) **System and method for generating physical deterministic boundary interconnect features for dual patterning technologies**

(30) Priority: 01.08.2012 US 201213564159
(71) Applicant: LSI Corporation, Milpitas, CA 95035 (US)
(72) Inventor: Milinchik, John A., Allentown, PA Pennsylvania 18103 (US); Delpero, Daniel J., Allentown, PA Pennsylvania 18104 (US); Bertino, Scott N., Barto, PA Pennsylvania 19504 (US); Smooha, Yehuda, Allentown, PA Pennsylvania 18104 (US); Harleman, Gregg R., Jim Thorpe, PA Pennsylvania 18229 (US)
(74) Representative: Williams, David John

(57) **Abstract**

One aspect provides a system for generating a layout for dual patterning technologies. In one embodiment, the system includes: (1) a deterministic boundary interconnect feature generator configured to generate a deterministic boundary interconnect feature for a cell based on at least one dual patterning design rule; and (2) cell placement and interconnect routing tools associated with the deterministic boundary interconnect feature generator and configured to place the deterministic boundary interconnect feature and other features of the cell relative thereto.

## Description

### TECHNICAL FIELD

This application is directed, in general, to a integrated circuits (ICs) and, more specifically, to IC design techniques in the context of dual patterning.

### BACKGROUND

Circuit designers use electronic design automation (EDA) tools, a category of computer-aided design (CAD) tools, for designing and laying out electronic circuits, including formulating the logic that underlies the operation of the circuit, simulating the operation of the circuit, determining where cells (*i.e.*, logic elements including devices, *e.g.*, transistors) should be placed and where the interconnects that couple the cells together should be routed. EDA tools allow designers to construct a circuit and simulate its performance using a computer and without requiring the costly and lengthy process of manual fabrication. EDA tools are indispensable for designing modern ICs, particularly very-large-scale integrated circuits (VLSICs). For this reason, EDA tools are in wide use.

During an initial, "design," stage, circuit designers employ one or more EDA tools to create a logical representation of a desired electronic circuit. After becoming satisfied (typically through simulation) that the logical representation of the circuit operates as intended, the circuit designers then employ EDA tools called "IC compilers" (ICCs) to transform the logical representation (typically embodied in a "netlist") automatically into a corresponding physical representation of each cell in the circuit on one or more photolithography masks in an "implementation" stage. The implementation stage typically includes two substages: a "placement" substage in which appropriate gates are selected from a library and placed relative to one another in an area representing a substrate which will support the cell, and a "routing" substage in which local interconnects are routed across the substrate within the cell to yield a cohesive electronic circuit. The cells are then placed relative to one another and inter-cell interconnects are laid out to yield a physical representation of the entire IC, or "chip." The photolithography masks are eventually used to create layers of IC features on substrates and thereby form ICs.

Feature sizes in very-large-scale IC (VLSIC) technologies, particularly of the complementary interconnect-oxide semiconductor (CMOS) type, continue to shrink. Unfortunately, the wavelengths of light used in photolithography to make the features are not shrinking as quickly. Accordingly, various advances have been made in photolithographic techniques that allow it to keep up with shrinking feature sizes. These techniques include phase shift masks and, most recently, dual patterning. Dual patterning uses two photolithography masks, instead of just one, to define fine-pitch features in a VLSIC.

The lithographical challenges of the latest CMOS technologies (typically 20nm and lower) require dual patterning not only of gates, but local interconnects and even some thin interconnect routing layers. Unfortunately, dual patterning requires complex design rules that determine where features may and may not be placed on the two masks. While necessary, these design rules present significant IC layout challenges, especially at boundaries between adjoining input/output (I/O) buffers or support cells such as electrostatic discharge protection clamps. The challenges become particularly acute when adjoining buffers or cells are laid out according to different requirements. A cell layout that appears reasonable in isolation may nonetheless cause violations when that layout is placed adjacent other cell layouts. Large core blocks may also have issues' with nearby interconnects or chip-layer fill patterns given the special interconnect design rules for the double-patterned interconnects.

### SUMMARY

One aspect provides a system for generating a layout for dual patterning technologies. In one embodiment, the system includes: (1) a deterministic boundary interconnect feature generator configured to generate a deterministic boundary interconnect feature for a cell based on at least one dual patterning design rule and (2) cell placement and interconnect routing tools associated with the deterministic boundary interconnect feature generator and configured to place the deterministic boundary interconnect feature and other features of the cell relative thereto.

Another aspect provides a method of generating a layout for dual patterning technologies. In one embodiment, the method includes: (1) generating a deterministic boundary interconnect feature for a cell based on at least one dual patterning design rule and (2) placing the deterministic boundary interconnect feature and other features of the cell relative thereto.

Yet another aspect provides a computer-readable storage medium containing program instructions for designing and implementing a circuit using mixed cell libraries. In one embodiment, execution of the program instructions by one or more processors of a computer system causes the or more processors to: (1) generate a deterministic boundary interconnect feature for a cell based on at least one dual patterning design rule and (2) place the deterministic boundary interconnect feature and other features of the cell relative thereto.

### BRIEF DESCRIPTION

Reference is now made to the following descriptions taken in conjunction with the accompanying drawings, in which:
FIG. 1 is a diagram of an I/O ring of an IC;
FIG. 2A is a diagram of an I/O buffer cell of an IC laid out according to conventional design rules;
FIG. 2B is a diagram of an I/O buffer cell of an IC laid out with the benefit of a deterministic boundary interconnect feature (DBIF) embodiment;
FIG. 3 is a diagram of three adjacent I/O buffer cells laid out according to conventional design rules;
FIG. 4 is a more detailed portion of the diagram of FIG. 3;
FIG. 5 is a diagram of three adjacent I/O buffer cells laid out with the benefit of U-shaped DBIF embodiments;
FIG. 6 is a more detailed portion of the diagram of FIG. 5;
FIG. 7 is a diagram of three adjacent I/O buffer cells laid out with the benefit of side-cell DBIF embodiments;
FIG. 8 is a diagram of three adjacent I/O buffer cells laid out with the benefit of U-shaped DBIF embodiments having a P-substrate tie;
FIG. 9 is a diagram of a local interconnect layer of three adjacent I/O buffer cells laid out with the benefit of side-cell DBIF embodiments;
FIG. 10 is a more detailed portion of the diagram of FIG. 9;
FIG. 11 is a diagram of a core block having a full-ring DBIF embodiment; and
FIG. 12 is a hybrid block/flow diagram of one embodiment of a system and method for generating physical deterministic boundary interconnect features for dual patterning CMOS technologies.

### DETAILED DESCRIPTION

In the past, dual patterning only affected the gates in a given IC design. However, dual patterning now affects local interconnect layers and has even made inroads to several thin interconnect layers.

The conventional approach for dealing with I/O buffer boundary conditions involves either employing simple minimum-spacing design rules to ensure a minimum spacing between internal interconnects and cell boundaries, or defining a "no-features-allowed zone" that is utterly devoid of features. This conventional approach allows I/O buffers and support cells that are in the same "family" (*i.e.*, have the same top-layer power busing) to be mixed and matched. Unfortunately, a verification process must be undertaken to prove that the design rules are proper. To verify the design rules, a large test cell is required to be created with all possible combinations of cells. The verification process was found to be adequate with older process technologies having simple design rules, but newer, dual patterning CMOS technologies have far more complex design rules, including voltage-dependent spacing design rules and forbidden gap design rules (where spacing in a certain distance range from other interconnects is not allowed). These are only a few types of design rules that may exist in a particular application.

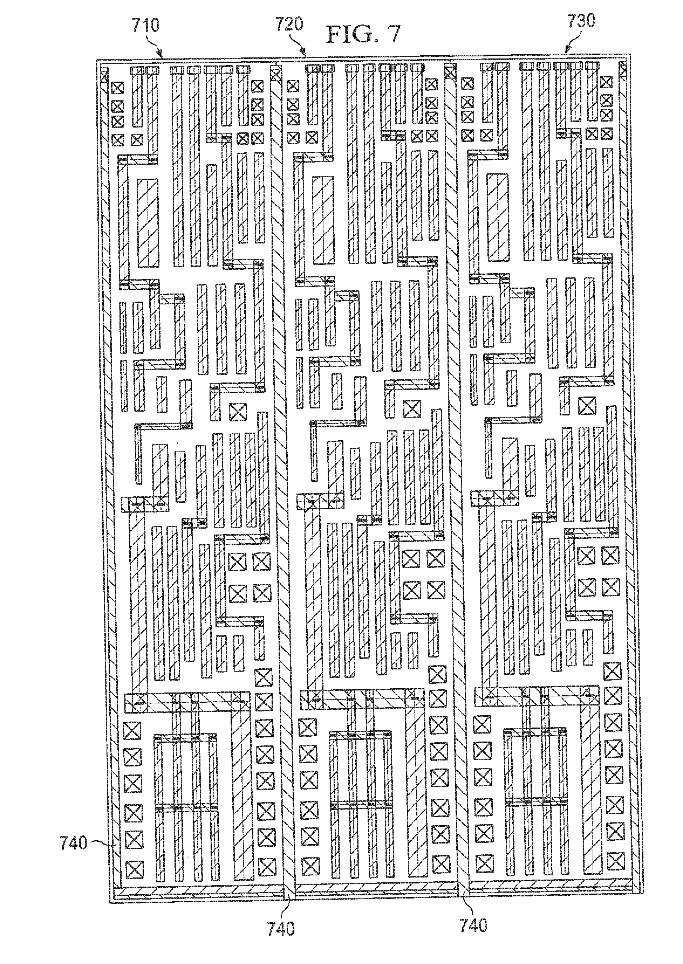

For example, if a minimum spacing design rule enforces a 50nm spacing, keeping interconnects inside a given cell boundary by 25nm would comply. Unfortunately, the latest, state-of-the art CMOS technologies may create violations even when following conventional minimum spacing design rules. For example, if the I/O buffer that has an interconnect 25nm from the cell boundary is butted to a cell with an interconnect 45nm (which is much more than minimum) away from the cell boundary, and there is a forbidden gap design rule barring interconnects from being spaced from each other in a range of 60nm to 110nm, the interconnects would be 70nm away from each other which violates the forbidden gap design rule (as will be shown below in conjunction with FIG. 7). Complicating the design, forbidden gaps change as a function of interconnect width, so it is difficult to predict where to place interconnects based on the interconnects in possible adjoining cell.

To further aggravate the challenge, if the interconnect is placed for this particular cell abutment, a different cell abutment may have a different set of boundary placement design rules, which could cause new violations in this "fixed" area. The result is that laying out features using the traditional methodology is tedious, time consuming, and tends to create unnecessarily large I/O buffers and support cells.

Similarly, for large core cells, the conventional approach was to place all interconnects no closer to the boundary than one-half of the minimum spacing specified by the minimum spacing design rule. Unfortunately, with all the different interconnect and via spacings required under multiple conditions, it is becoming difficult to choose a reasonable sized no-features-allowed zone where no interconnects can be placed. While enlarging the no-features-allowed zone may seem to be a reasonable solution, the resulting diminished windows for laying out interconnects could violate various interconnect density design rules. To remedy this, tedious manual work is required to be done around each core block circuit to get just the right balance of interconnect, via spacing and interconnect density for the dual patterned interconnects. This is not an acceptable solution.

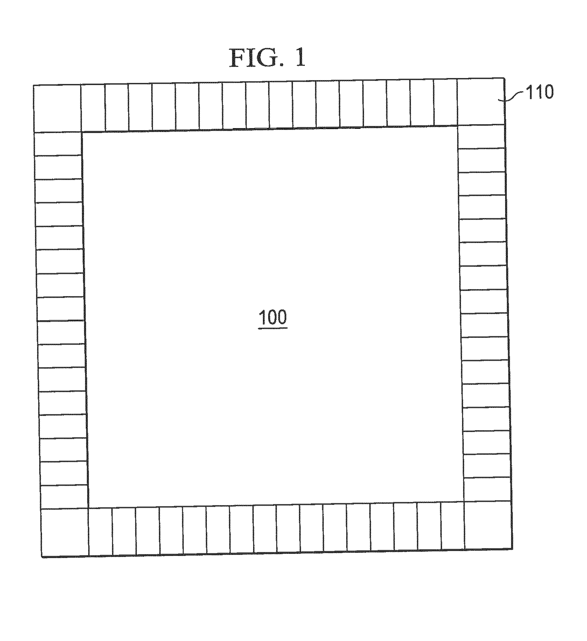

As those skilled in the pertinent art are aware, dual-patterning design rules typically include forbidden spacing design rules, voltage-dependent spacing design rules, via spacing design rules, density design rules, and special dual pattern spacing/feature design rules. Laying out features close to the boundary of an block, especially laying out I/O buffer cells that are often placed adjoining to each other can become very difficult and subject to trial and error. FIG. 1, which is a layout of an I/O ring 110 of an IC 100, illustrates this point. The I/O ring 110 contains a plurality of I/O buffer cells (unreferenced) laid out adjacent one another. As described above, this adjacency gives rise to the need for complex design rules when feature sizes in particular layers are of such fine pitch that dual patterning is required. Compounding the problem is that different I/O buffer cells are often laid out by different designers, and they are laid out to optimize the layout of the single I/O buffer cell. In practical environments, the designers are not aware of the boundary conditions prevailing in adjacent buffer or cell ahead of time. These uncertainties frustrate the designer and the layout effort, because layout violations require manual and time-consuming repair.

Accordingly, it is realized herein that a need exists to reduce uncertainties at the boundaries of I/O buffers. In accordance with the disclosure herein, the concept of a DBIF is introduced. A DBIF is defined as a physical feature (*i.e.*, formed of one or more conductive, typically metal, materials) that: (1) is defined and laid out using one or more dual patterning design rules and (2) prevents other features from being colocated with it. A DBIF creates a deterministic routing boundary for one or more layers of a cell or block that reduces, and perhaps altogether avoids violations of the one or more dual patterning design rules used to define and lay out the DBIF. Therefore, a DBIF exists primarily to discourage, and perhaps prevent, other features from violating one or more dual patterning design rules. For purposes of this disclosure, "dual patterning" encompasses the use of at least two photolithography masks to form a particular feature on a particular layer of a particular IC.

DBIFs are generated and placed on or proximate the boundaries, along one or more of the sides, of the I/O buffers and all potentially adjoining cells (*e.g.,* ESD clamps, capacitor cells, filler cells, and other support cells). The DBIFs allow designers to know exactly what the boundary features are and, consequently, all routing/interconnect related spacing, forbidden gap, and density design rules can be met with certainty. In certain embodiments, cell placement that would otherwise arise due to these issues completely disappear.

Large core circuit blocks, such as SRAM and analog blocks, do not butt up to other blocks, but they are subject to the same type of non-deterministic boundary wiring and hence the same uncertainty of dual patterned interconnects spacing design rules as the I/O buffers. Accordingly, some embodiments of the system and method described herein are configured to provide deterministic boundary features to large core circuit blocks. Place and route tools that are fed with the boundary feature placement inside a block (analog, I/O, *etc*.) can be instructed to place routes next to the block that will be correct by construction.

A DBIF gives a designer a deterministic (*i.e*., known) boundary and bounds all internal double patterned interconnects and interconnect fill features, preventing the complex layout design rules for dual patterned interconnect features between various I/O buffers and support cells from being violated. For large core blocks, such as SRAMs or analog blocks, the DBIF bounds the dual patterned internal interconnect and interconnect fill layers and thereby prevents them from causing violations with external wiring due to unforeseen conditions. The DBIF creates a consistent, deterministic boundary, where simple design rules can be applied to route around the cell with no need to take into account forbidden gaps, large via spacing design rules, voltage dependent spacing design rules and other special dual pattern feature design rules to internal wiring.

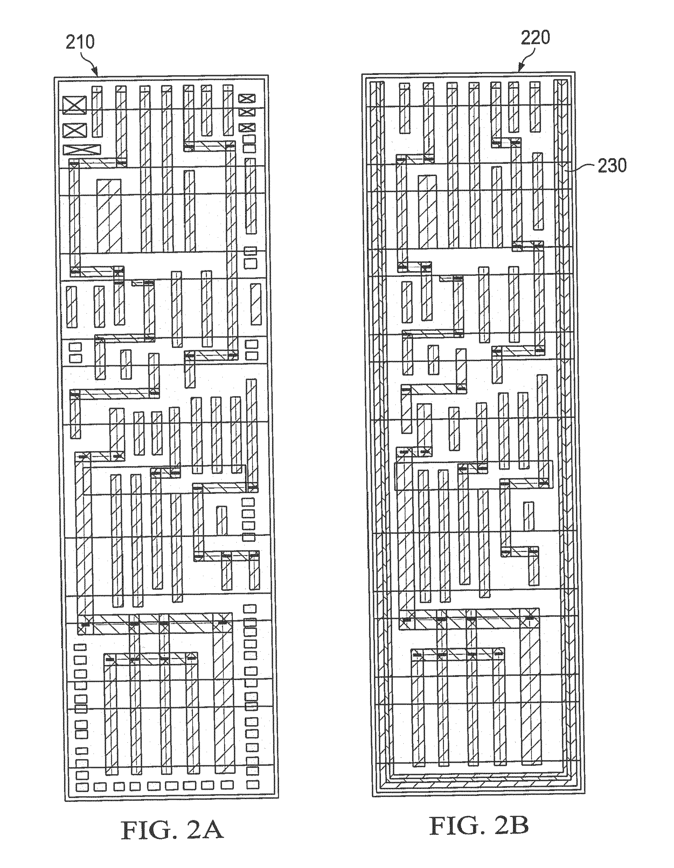

Various embodiments of DBIFs described herein include both local (*i.e.*, intra-cell) and inter-cell portions that together serve physically to separate internal dual patterned features from external dual patterned features (as will be shown in conjunction with FIGs. 2A, 8, 9 and 10, below). While most DBIF embodiments are relatively long and extend along the entirety of one or more sides of a cell, DBIFs are generally intended to encompass such areas as needed to ensure design rule compliance; other areas may be included in the DBIFs for completeness or ease of generation. For example, if a cell has several local interconnects, and all of the local interconnects have minimum spacing requirements from one of the interconnects, that local interconnect should be taken into account in generating the DBIF. Other local interconnects could be included, but this could make the DBIF larger than necessary. The features placed about the DBIF need not be maximally dense; if a local interconnect needs to be placed farther from the cell boundary than the interconnects for design rule purposes, it can be offset. If any interconnect layer needs to be wider or narrower for design rule purposes, it can be modified or offset. If the interconnect spacing features themselves limit local interconnect placement and prevent local interconnect from interacting across cell boundaries, the DBIF can be designed without local interconnects.

The sizes and shapes of various embodiments of the DBIF can vary. A DBIF can be a ring around a whole cell and is a good solution for I/Os and for large core blocks. A DBIF can be a U-shaped, leaving one side open for terminal connections. A DBIF can encompass just the right and left sides of a cell if the top and bottom adjoining cells are consistent, such as when the bottom is a sealring, and the top does not adjoin any cell, but is instead open to a routing area with many terminal features to help bound the top edge interconnect condition. If the I/O ring placement methodology allows cell features to exceed the place and route (P&R) boundary, the DBIF could also go on the P&R boundary itself and be overlapped if allowed by the methodology and P&R tools.

Various embodiments of the DBIF can be used for I/O buffers and I/O support cells, such as (but not limited to) ESD clamps, capacitor cells, filler cells, and other I/O ring cells. These features can also be used for core block cells, such as (but not limited to) memories (*e.g.*, static random-access memory, or SRAM, read-only memory, or ROM, or content-addressable memory, or CAM), analog circuits (phase-locked loops, or PLLs, temperature sensors, or read-channels), and other large digital blocks.

In various embodiments, all of the DBIFs in the same family use the same number of interconnect layers, preferably all the dual patterned interconnects, and the minimum local interconnect layers to design-rule-bound the cell boundaries. Non-dual patterned interconnect layers do not need to be included, but could be if desired to bound them as well. If any length restrictions exist, the interconnects can be overlapped and the gaps between interconnects of the same interconnects staggered. Example, if a 10µm length restriction exists for a local interconnect, and two local interconnects are included, the first one could go at 5µm, then gap and continue in 10µm lengths throughout the rest of the design, while the next local interconnect would go at 10µm, then gap, then continue in 10µm lengths, thus having shapes overlapping the gaps.

In various embodiments, the DBIF is connected to a power rail of the IC. In a more specific embodiment, all DBIFs in an I/O buffer family are connected to the same voltage layer to keep design rules consistent between or among I/O buffers. For large core block cells, in which there are no family requirements, an appropriate voltage layer should be considered, such as ground. A DBIF is not used to provide power to any internal circuitry of the IC, but could be used in capacitors. Alternative embodiments of the DBIF are left floating, or parts could be left floating if design rules allow. For example, the interconnect interconnects could be grounded while the local interconnect could be left floating.

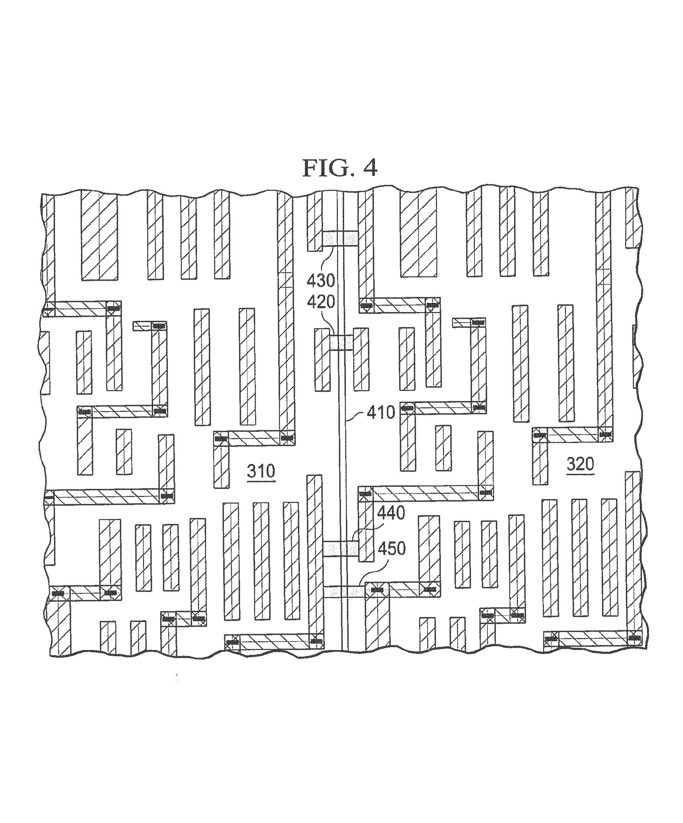

According to the teachings herein, the I/O buffers and support cells will have the double patterned local interconnect and interconnect interconnects placed in either a ring inside the cell boundary, or a U-shape on the sides and bottom (inside the cell boundary) leaving the core facing side open and letting the typically numerous and large core facing terminals define the interconnect boundary along that side of the cell, or on at least two facing sides of the cell except for a small spacing at the top and bottom (assuming that the bottom of the I/O will be deterministic due to the placement of the sealring, as FIG. 4 illustrates.

FIG. 2A is a diagram of an I/O buffer cell 210 of an IC laid out according to conventional design rules. FIG. 2B is a diagram of an I/O buffer cell 220 of an IC laid out with the benefit of one embodiment of a DBIF 230. The DBIF 230 has a U-shape and bounds the left-hand, bottom and right-hand sides of the I/O buffer cell 220 as FIG. 2B illustrates. In the embodiment of FIG. 2B, the DBIF 230 physically bounds the interconnect interconnects. It should be noted that FIGs. 2A and 2B do not show transistors; only M2, M3 and M5 interconnect layers are shown for clarity.

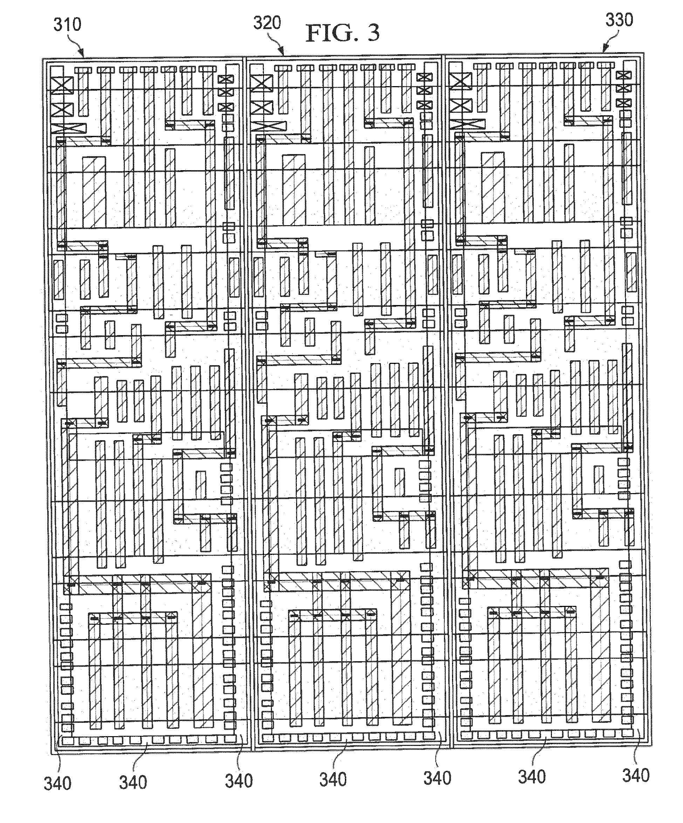

FIG. 3 is a diagram of three adjacent I/O buffer cells 310, 320, 330 laid out according to conventional design rules. It should be noted that FIG. 3 does not show transistors; only M2, M3 and M5 interconnect layers are shown for clarity. Areas 340 represent buffer where interconnects are allowed to be placed to avoid violating the relatively simple minimum spacing design rules that apply even in layers that are not dual patterned. However, interconnects in these areas 340, and even farther into the buffer cells 310, 320, 330, are still in danger of violating dual patterned design rules (*e.g.*, forbidden gap, wide interconnect spacing design rules and voltage-dependent design rules).

FIG. 4 is a more detailed portion of the diagram of FIG. 3. FIG. 4 well illustrates how close local interconnects can approach the cell boundary between the I/O buffer cells 310, 320, represented by a line 410. A rectangle 420 shows a properly tightly spaced set of interconnects. Unfortunately, a rectangle 430 show a forbidden gap violation; a rectangle 440 shows a voltage-dependent spacing violation (*e.g*., a 1 volt signal being too close to a 3 volt signal); and a rectangle 450 shows a wide-interconnect-to-thin-interconnect spacing violation.

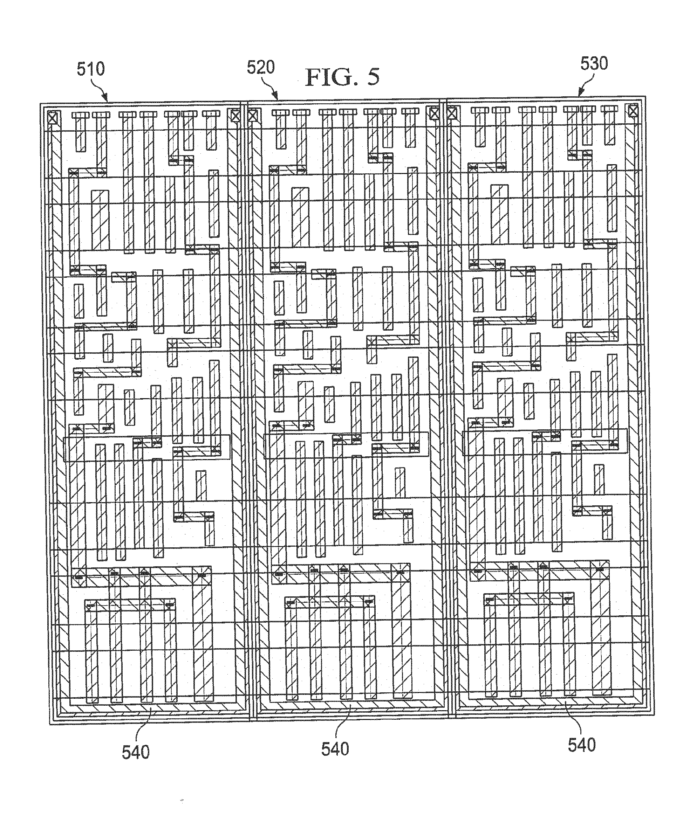

FIG. 5 is a diagram of three adjacent I/O buffer cells 510, 520, 530 laid out with the benefit of U-shaped DBIF embodiments 540. It should be noted that, like FIG. 3, FIG. 5 does not show transistors; only M2, M3 and M5 interconnect layers are shown for clarity.

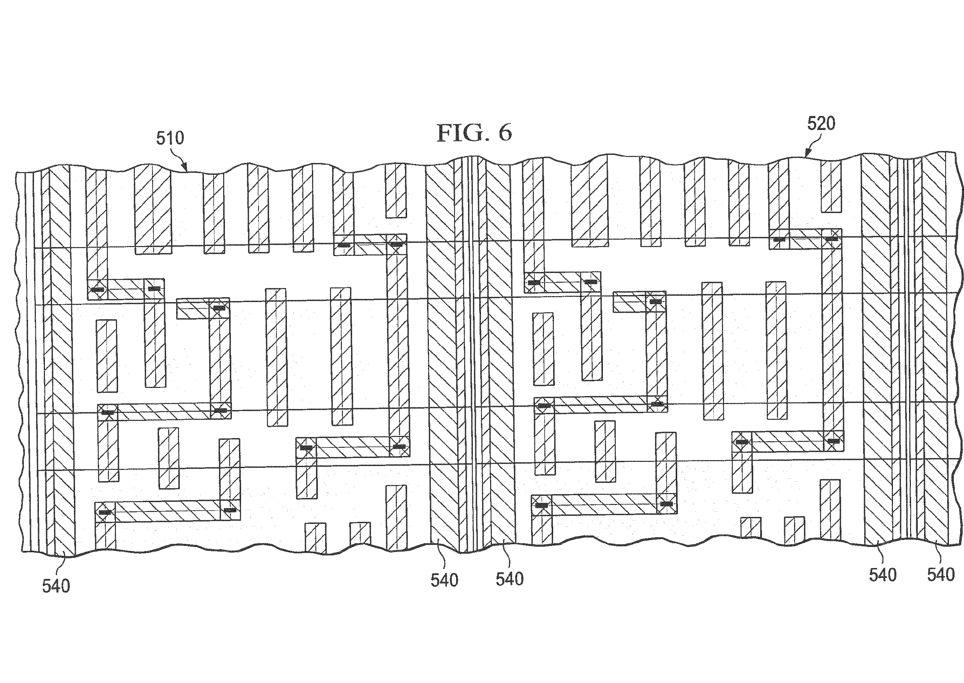

FIG. 6 is a more detailed portion of the diagram of FIG. 5. FIG. 6 shows how the DBIF embodiments 540 physically enforce the metal spacings internal to the I/O buffer cells 510, 520. Each of the I/O buffer cells 510, 520 includes a plurality of local interconnects. The metal in the DBIF creates a known boundary to interconnects in the next buffer cell's DBIF. The internal metal from the two buffers will only interact with their local DBIF which physically isolates the local interconnects of each buffer from interacting. Only the physically consistent DBIFs interact across the cell boundaries thus removing the complexity and uncertainty of internal dual patterned routing interacting across the cell boundaries with another cell.

If the I/O ring methodology allows it, DBIFs can be placed on the cell boundaries themselves and be overlapped, as FIG. 7 illustrates. FIG. 7 is a diagram of three adjacent I/O buffer cells 710, 720, 730 laid out with the benefit of side-cell DBIF embodiments 740. Note that the bottoms of each of the DBIF embodiments 740 are still inside the boundaries of the I/O buffer cells 710, 720, 730. This is for use in I/O ring cells that have a P&R methodology that allow features to cross the cell PR boundary and allowed to overlap with other cells.

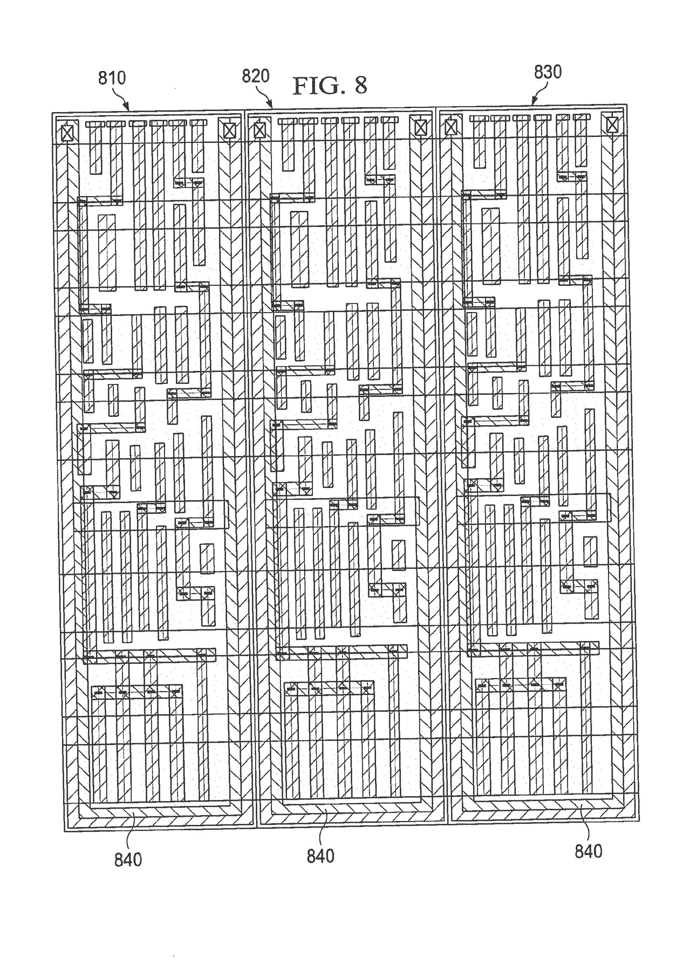

Due to the possible use of support cells such as capacitors or ESD cells between the searing and the bottom of the I/O buffer/support cells, the U-shape or total ring would be most beneficial. For large core blocks such as SRAMs or analog blocks such as PLLs, serializer/deserializer (serdes) circuits or temperature sensors, the entire cell would be ringed with the double patterned interconnect with the possible exception of openings for terminals. In one embodiment, the DBIF includes a substrate tie which would also bound the base layers as well as local interconnects and interconnect 1, as FIG. 8 shows. FIG. 8 is a diagram of three adjacent I/O buffer cells 810, 820, 830 laid out with the benefit of U-shaped DBIF embodiments 840 having a P-substrate tie. Alternative DBIF embodiments are complete rings around the I/O buffer cells 810, 820, 830. In the embodiment of FIG. 8, the P-substrate tie incorporates the local interconnects as well as ml and the active layer and implant layers to further bound all base layers (not dual patterned yet) as well as dual-patterned layers.

In the illustrated embodiments, the stacked interconnect layers are placed inside the cell boundary of all I/O buffers and support cells in a family so that when any two family cells are placed side by side, they pass the complex dual pattern feature design rules, but remain sufficiently close so as not adversely to affect interconnect density and internal cell routing significantly.

As stated above, the tried and true method of using a no-features-allowed zone around an I/O buffer, I/O support cells, or large core cell does not work with the new technologies using dual patterned local interconnect and interconnect due to all the new and complex design rules for dual patterned features and due to new voltage dependant interconnect spacing design rules. The invention of the Deterministic Boundary Interconnect Feature (DBIF), which is a physical feature, will reduce design time and simplify layout of potentially adjoining I/O buffer cells. It will also ease the design of large core cells such as memories and analog blocks as the DBIF will create a physical boundary to separate internal and external features and keep them both DRC clean to a known dual patterned interconnect feature.

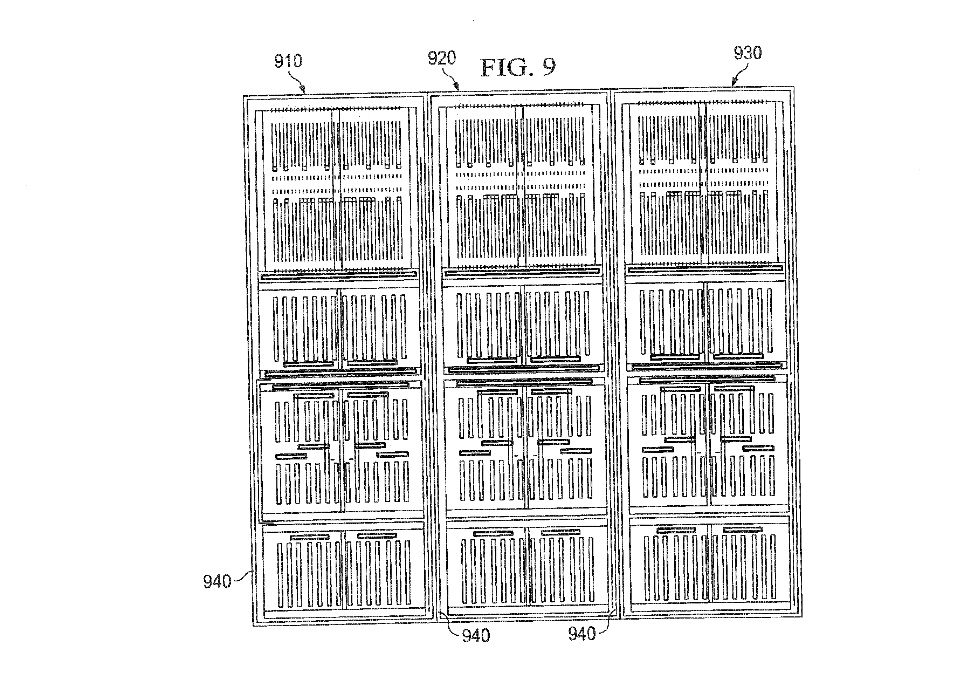

FIG. 9 is a diagram of a local interconnect layer of three adjacent I/O buffer cells 910, 920, 930 laid out with the benefit of side-cell DBIF embodiments 940. FIG. 9 is presented primarily for the purpose of showing side-cell DBIF embodiments 940 in the context of adjacent I/O buffer cells 910, 920, 930, wherein the DBIF embodiments 940 employ local interconnects as part of their overall structure.

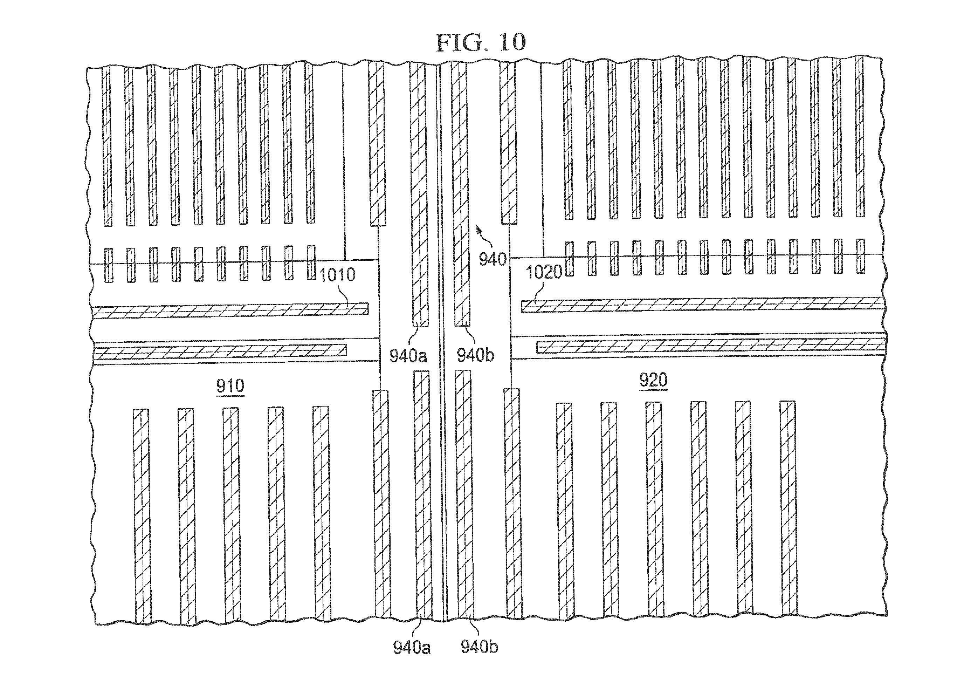

FIG. 10 is a more detailed portion of the diagram of FIG. 9, specifically showing a close up of a local interconnect at the DBIF. Horizontally running local interconnects 1010, 1020 are bounded a DBIF 940. In FIG. 10, the DBIF 940 includes two vertical local interconnects 940a, 940b. However, only one of the vertical local interconnects 940a, 940b may be employed as part of the DBIF 940. However, two have been included to accommodate density. If density is not a concern, and bounding the local interconnects alone would ensure that they cannot violate any double patterned design rules across abutted cell boundaries, the local interconnect need not be a part of the DBIF 940.

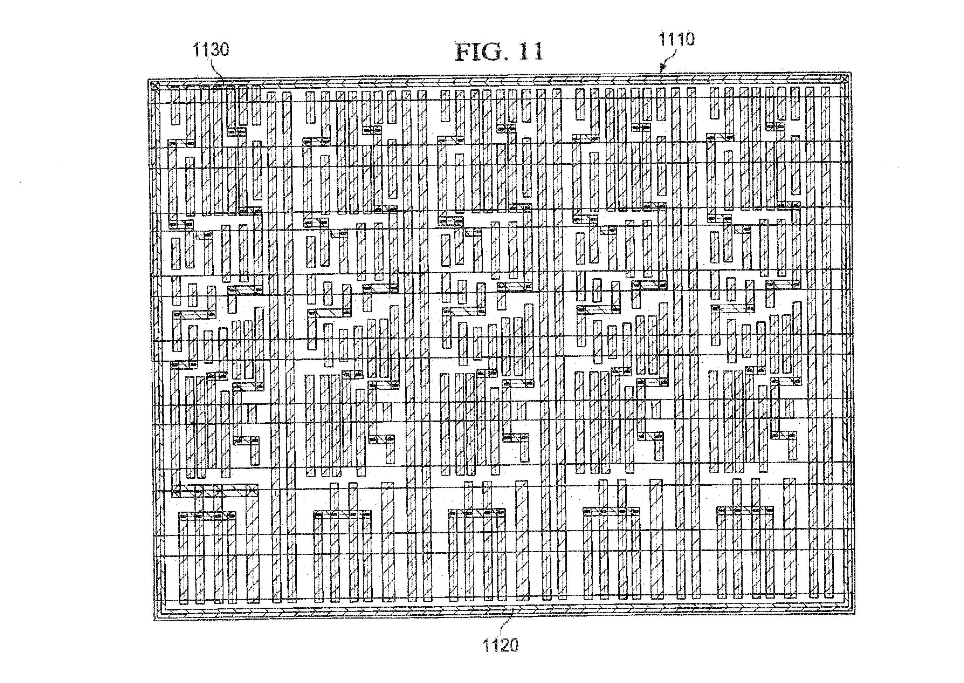

FIG. 11 is a diagram of a core block having a full-ring DBIF embodiment. FIG. 11 shows a core block 1110 fully ringed with a DBIF 1120, except for metal 2 in the upper left hand corner 1130 where terminal pins are located.

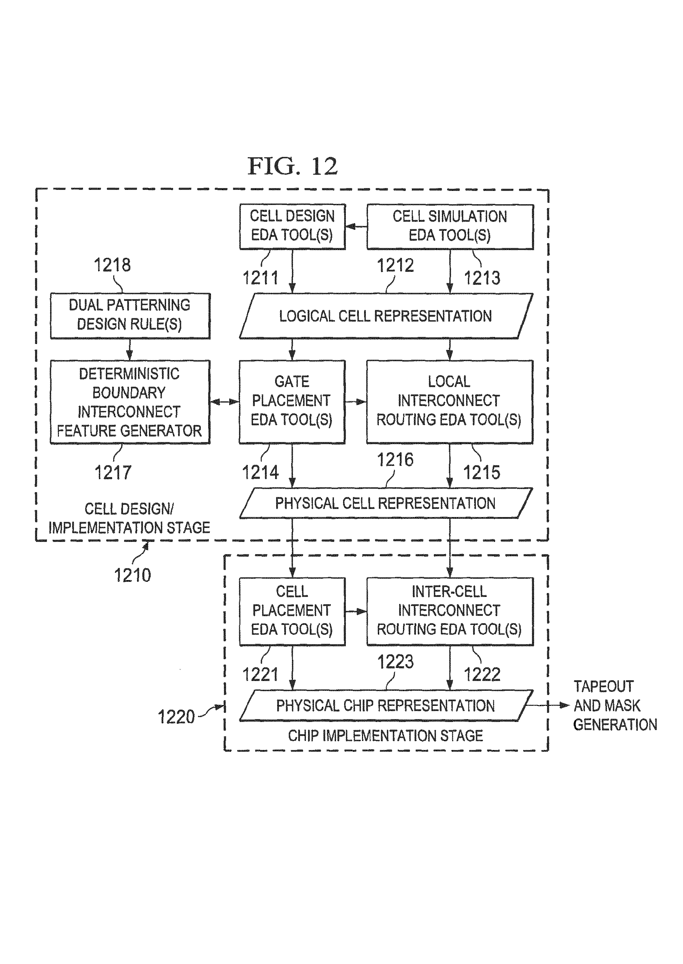

FIG. 12 is a hybrid block/flow diagram of one embodiment of a system and method for generating physical DBIFs for dual patterning CMOS technologies. FIG. 12 shows two stages (perhaps among others) in a circuit creation process: a cell design/implementation stage 1210 and a chip implementation stage 1220.

In the cell design/implementation stage 1210, one or more designers employ one or more cell design EDA tools 1211 to create a logical cell representation 1212. In the illustrated embodiment, a netlist expresses the logical cell representation 1212. The one or more designers then typically subject the logical cell representation 1212 to one or more simulations using one or more cell simulation EDA tools 1213. The results of the one or more simulations may prompt the one or more designers to modify the logical cell representation 1212 until it operates as intended.

One or more gate placement EDA tools 1214 and one or more local interconnect routing EDA tools 1215 are then employed to transform the logical cell representation 1212 into a physical cell representation 1216 by placing gates and local interconnects. However, before gates or local interconnects are placed, a determination is made whether or not certain layers of an IC implementing the logical cell representation 1212 require dual patterning. If one or more layers require dual patterning, the teachings of the disclosure herein call for the generation of a DBIF for the cell. As a result, a DBIF will be generated and laid out first thereby to prevent gates and local interconnects laid out subsequently from violating dual patterning design rules.

Accordingly, in the embodiment of FIG. 12, assuming one or more layers require dual patterning, the one or more gate placement EDA tools 1214 invoke a DBIF generator 1217. The DBIF generator 1217 is configured to generate a DBIF for at least layers of the cell requiring dual patterning based on at least one dual patterning design rule. In the embodiment of FIG. 12, the at least one dual patterning design rule is contained in a dual patterning design rule database 1218, which may be a separate database or part of another database.

Having generated a DBIF for the cell, the one or more gate placement EDA tools 1214 then first place the DBIF. After having first placed the DBIF, the one or more gate placement EDA tools 1214 then place gates in the cell. Once gates are placed, the one or more local interconnect routing EDA tools 1215, associated with the one or more gate placement EDA tools 1214, are configured to route local interconnects within the cell.

Arrowheaded lines extending among the one or more cell design EDA tools 1211, the logical cell representation 1212, the one or more cell simulation tools 1213, the one or more gate placement EDA tools 1214, the one or more local interconnect routing EDA tools 1215, the physical cell implementation 1216, the DBIF generator 1217 and the database 1218 and are intended schematically to represent information flow and the iterative nature of at least some of the process occurring within the cell design/implementation stage 1210.

In the chip implementation stage 1220, one or more cell placement EDA tools 1221 are employed to transform the physical cell representation 1216, together with physical cell representations of other cells (not shown) into a physical chip representation 1223 by placing cells relative to one another.

Further in the chip implementation stage 1220, one or more inter-cell interconnect routing EDA tools 1222, associated with the one or more cell placement EDA tools 1221, are configured to route inter-cell interconnects among the cells. Arrowheaded lines extending among the one or more cell placement EDA tools 1221, the one or more inter-cell interconnect routing tools 1222 and the physical chip representation 1223 are intended schematically to represent the general flow of the process occurring within the chip implementation stage 1220.

When the physical chip representation 1223 is complete, further simulations may take place to confirm its proper operation. Eventually, the physical chip representation 1223 is employed to generate masks that are employed in photolithographic circuit fabrication equipment, whereupon a milestone called "tapeout" is reached, as FIG. 12 shows.

It should be noted that various commercially available EDA tools may be configured to carry out the above-described system and method. In one embodiment, the DBIF generator 1217 takes the form of a program, perhaps a script, executing within the environment of a commercially available gate placement EDA tool. For example, the Galaxy Custom Designer is a gate placement EDA tool commercially available from Synopsys, Inc., of Mountain View, California. Accordingly, the various embodiments of the system and method described herein may take the form of a computer-readable storage medium containing program instructions for designing and implementing a circuit using mixed cell libraries. In one embodiment, execution of the program instructions by one or more processors of a computer system causes the one or more processors to: (1) generate a deterministic boundary interconnect feature for a cell based on at least one dual patterning design rule and (2) place the deterministic boundary interconnect feature and other features of the cell relative thereto.

Those skilled in the art to which this application relates will appreciate that other and further additions, deletions, substitutions and modifications may be made to the described embodiments.

## Claims

1. A system for generating a layout for dual patterning technologies, comprising:
a deterministic boundary interconnect feature generator configured to generate a deterministic boundary interconnect feature for a cell based on at least one dual patterning design rule; and
cell placement and interconnect routing tools associated with said deterministic boundary interconnect feature generator and configured to place said deterministic boundary interconnect feature and other features of said cell relative thereto.

2. The system as recited in Claim 1 wherein said deterministic boundary interconnect feature generator is further configured to generate a family of deterministic boundary interconnect features using a same number of interconnect layers.

3. The system as recited in Claim 2 wherein said interconnect layers are limited to dual patterning layers.

4. The system as recited in Claim 1 wherein said deterministic boundary interconnect feature is configured to be connected to a power rail of an integrated circuit.

5. The system as recited in Claim 1 wherein said deterministic boundary interconnect feature is configured to be used in a capacitor.

6. The system as recited in Claim 1 wherein said deterministic boundary interconnect feature is one of a side-cell deterministic boundary interconnect feature and a U-shaped deterministic boundary interconnect feature and corresponds to one of an I/O buffer cell and an I/O support cell.

7. The system as recited in Claim 1 wherein said deterministic boundary interconnect feature is a full-ring deterministic boundary interconnect feature and corresponds to a core block cell.

8. The system as recited in Claim 1 wherein said deterministic boundary interconnect is a physical feature formed of one or more conductive materials that is defined and laid out using said at least one dual patterning design rule.

9. A method of generating a layout for dual patterning technologies, comprising:
generating a deterministic boundary interconnect feature for a cell based on at least one dual patterning design rule; and
placing said deterministic boundary interconnect feature and other features of said cell relative thereto.

10. A computer-readable storage medium containing program instructions for designing and implementing a circuit using mixed cell libraries, execution of said program instructions by one or more processors of a computer system causing said one or more processors to:
generate a deterministic boundary interconnect feature for a cell based on at least one dual patterning design rule; and
place said deterministic boundary interconnect feature and other features of said cell relative thereto.
